Europäisches Patentamt

European Patent Office

Office européen des brevets

(11) Publication number: **0 470 498 A2**

# EUROPEAN PATENT APPLICATION

(21) Application number: **91112897.3**

(22) Date of filing: **31.07.91**

(51) Int. Cl.5: **G11C 5/14**

(30) Priority: **31.07.90 US 560523**

(43) Date of publication of application:
**12.02.92 Bulletin 92/07**

(84) Designated Contracting States:
**DE FR GB IT NL**

(71) Applicant: **TEXAS INSTRUMENTS
INCORPORATED
13500 North Central Expressway
Dallas Texas 75265(US)**

(72) Inventor: **McAdams, Hugh P.
17158 South Ivy Cr.
Houston, Texas 77084(US)**

(74) Representative: **Leiser, Gottfried, Dipl.-Ing. et
al
Patentanwälte Prinz, Leiser, Bunke & Partner
Manzingerweg 7
W-8000 München 60(DE)**

(54) **Improvements in or relating to integrated circuits.**

(57) A voltage reference initialization circuit for a voltage reference generator is disclosed. The initialization circuit has a starter circuit connected to the input of the voltage reference generator and to an external voltage supply to initially couple the input of the reference generator to the external voltage supply and thereby start the reference generator. It also has a pump circuit. The pump circuit is connected to the input of the voltage reference generator and to the external voltage supply. It is coupled to the output of the reference generator. The pump circuit pumps a fixed charge from the external voltage supply into the voltage reference generator. Such a circuit may be incorporated into a semiconductor memory device having an on chip voltage reference generator.

Fig. 10

This invention relates to integrated circuits, and in particular to integrated circuit devices formed in a semiconductor substrate, for example memory devices such as dynamic random access memories.

The development of very large scale integrated circuit (VLSI) semiconductor devices of the Dynamic Random Access Memory (DRAM) type is well known. Over the years, the industry has steadily progressed from DRAMS of the 16K type (as shown in the U.S. Pat. 4,055,444 issued to Rao) to DRAMS of the 1MB type (as shown in U.S. Pat. 4,658,377 issued to McElroy), and progressed to DRAMS of the 4MB type. A 16MB DRAM, wherein more than 16 million memory cells and associated circuitry are integrated on a single memory chip, is the next generation of DRAM scheduled for production.

Presently in designing VLSI semiconductor memory devices of the 16MB DRAM type, designers are faced with numerous challenges.

One cause for concern, for example, is sensitivity to external supply variations. Another concern is device power consumption and overall power dissipation of the chip, particularly if on chip supply regulation is employed. Accordingly, it is an object of the present invention to provide a circuit for generating a voltage reference which is used to ensure accurate control of voltage generation circuitry for an integrated circuit device. A further object is to provide a circuit which performs adequately at power up.

According to the present invention in one aspect thereof;

a voltage reference initialization circuit for a voltage reference generator comprises:

a starter circuit connected to the input of the voltage reference generator and to an external voltage supply, initially to couple the input of the reference generator to the external voltage supply and thereby start the reference generator; and

a pump circuit connected to the input of the reference generator, coupled to the output of the reference generator, and connected to the external voltage supply, to pump a fixed charge from the external voltage supply into the voltage reference generator in dependence upon said reference generator output.

Preferably, the pump circuit includes:

a capacitor connected to the input of the voltage reference generator; and

a transistor coupled between the external voltage supply and the capacitor, the gate of the transistor being coupled to the output of the voltage reference generator.

Advantageously, the pump circuit further includes:

a pulse generation circuit coupled to the capacitor wherein the capacitor charges in response to the pulses it receives from the pulse generation circuit.

According to the present invention in a further aspect thereof;

the voltage reference generator and the voltage reference generator initialization circuit may form part of an integrated circuit device.

The integrated circuit device may include means for biasing the device substrate, said starter circuit being energized when said biasing means is active.

In a preferred form of the present invention an integrated circuit device includes:

an array of memory cells;

circuitry for writing and reading information into and from said cells of said array;

said array being supplied from a voltage derived from said voltage reference generator.

Preferably, the circuitry for writing and reading information is supplied by said voltage reference generator output.

As part of this application an exemplary voltage generator is disclosed. The initialization circuit has a starter circuit connected to the input of the voltage reference generator and to an external voltage supply to initially couple the input of the reference generator to the external voltage supply and thereby start the reference generator. It also has a pump circuit. the pump circuit is connected to the input of the voltage reference generator and to the external voltage supply. It is coupled to the output of the reference generator. The pump circuit pumps a fixed charge from the external voltage supply into the voltage reference generator. Such a circuit may be incorporated into a semiconductor memory device having an on chip voltage reference generator.

Other objects, advantages and features of the invention will become apparent to those of ordinary skill in the art, having reference to the following description of embodiments of the invention which together with the accompanying drawings are provided by way only of example.

In the drawings:-

FIG. 1 is a block system level drawing illustrating a 16MB Dynamic Random Access Memory chip incorporating an embodiment of the invention,

FIG. 2 is a top view drawing illustrating the pin designations of the packaged memory chip,

FIG. 3 is a three-dimensional view of the packaged memory chip wherein the encapsulating material is rendered transparent,

FIG. 4 is an assembly view if FIG. 3,

FIG. 5 is a cross-sectional view of FIG. 3,

FIG. 6 is a top view drawing illustrating the bond pad designations of the memory chip,

FIG. 7 is a top view drawing illustrating a portion of the memory array,

FIG. 8 is a cross-sectional view of a portion of the memory array,

FIG. 9 is a side view of the cross-sectional view of FIG. 8,

FIG. 10 is a block diagram of a reference voltage generator and associated circuits,

FIG. 11 illustrates the VREF INIT circuit,

FIG. 12 illustrates the VDDREF or VDD Reference circuit,

FIG. 13 illustrates the Voltage Bandgap Reference circuit VBNDREF,

FIG. 14 illustrates the Voltage Multiplier circuit VMULT,

FIG. 15 illustrates the Power Up Boost Oscillator BOSC, and

FIG. 16 illustrates the Low Power Oscillator LPOSC.

An exemplary embodiment of the invention and a memory chip including the invention will now be described.

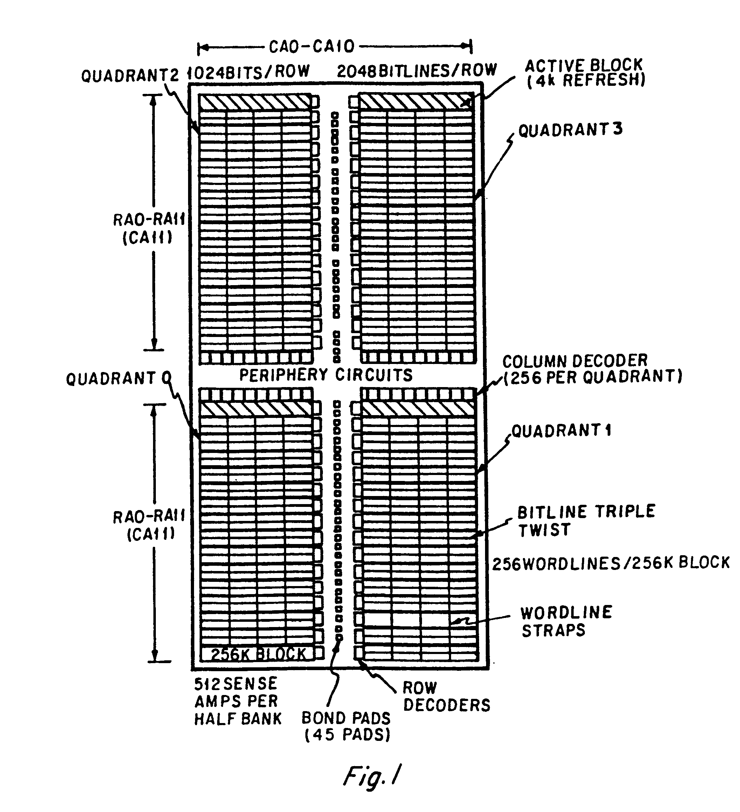

Fig. 1 illustrates a 16MB Dynamic Random Access Memory Chip referred to as a 16MB DRAM. The chip size is about 323 X 660 mm. The chip is partitioned into four memory array quadrants. Each memory array quadrant contains 4 Megabits. A 4MB memory array quadrant contains 16 memory blocks. Each memory block contains 256 Kilobits. The Column Decoders lie along the vertical axis of the chip adjacent to their respective memory array quadrants. The ROW decoders lie along the horizontal axis of the chip, adjacent to their respective memory array quadrants. The periphery circuits containing such devices as the input and output buffers and the timing and control circuits are centrally located along both the horizontal and the vertical axis of the chip. The bond pads are centrally located along the horizontal axis of the chip.

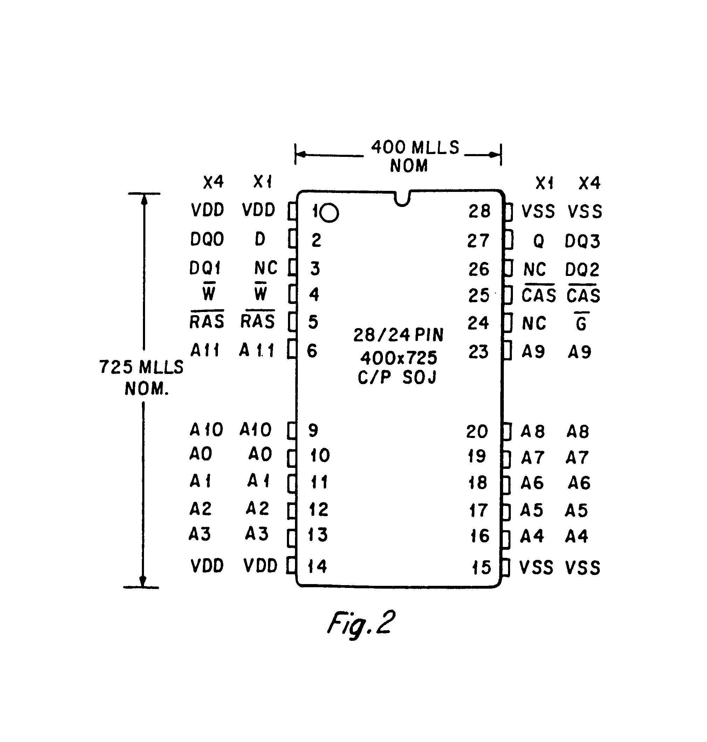

FIG. 2 is a top view drawing illustrating the package/pin out of the device. The chip is center bonded and encapsulated in a thin plastic, small outline J-type package. Among other features, the DRAM is bond programmable as either an X1 or an X4 device. The pin designations for both the X1 and X4 modes of operation are illustrated.

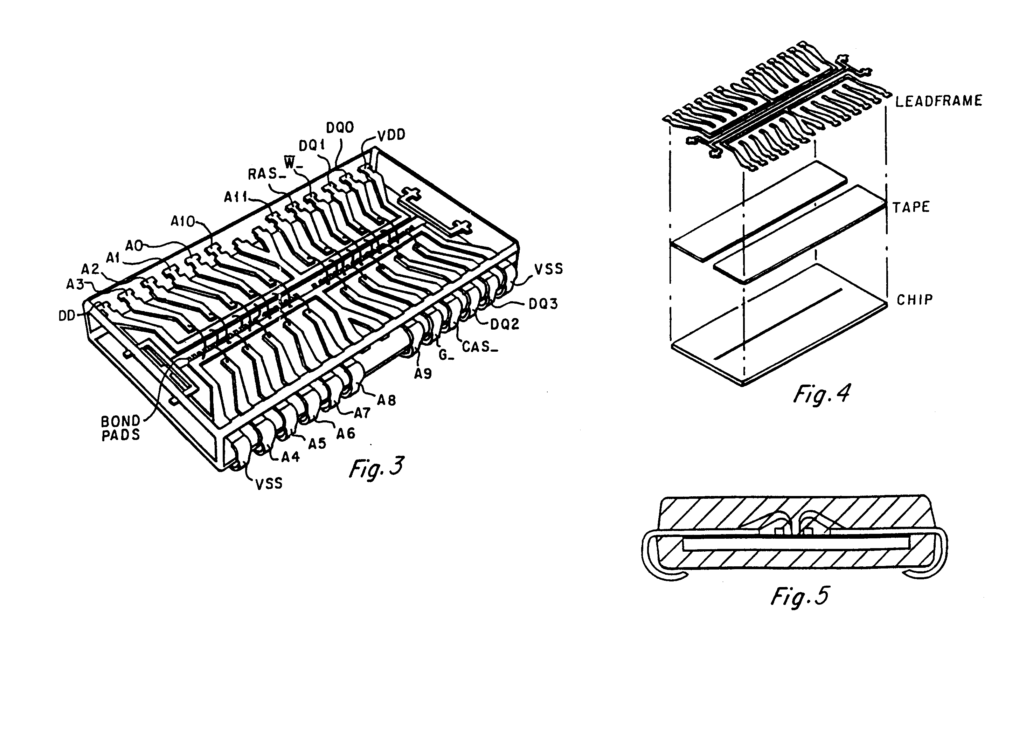

FIG. 3 is a three-dimensional view of the encapsulated chip wherein the encapsulating plastic is rendered transparent. The pin designations shown correspond to the X4 option. The TSOJ package is of the lead over chip with center bond (LOCCB) type. Basically, the chip lies underneath the lead fingers. A polyamide tape attaches the chip to the lead fingers. Gold wires are wire-bonded from the lead fingers to the center bonding pads of the chip.

FIG. 4 is an assembly view of the packaging concept and

FIG. 5 is a cross-section view of the packaged device.

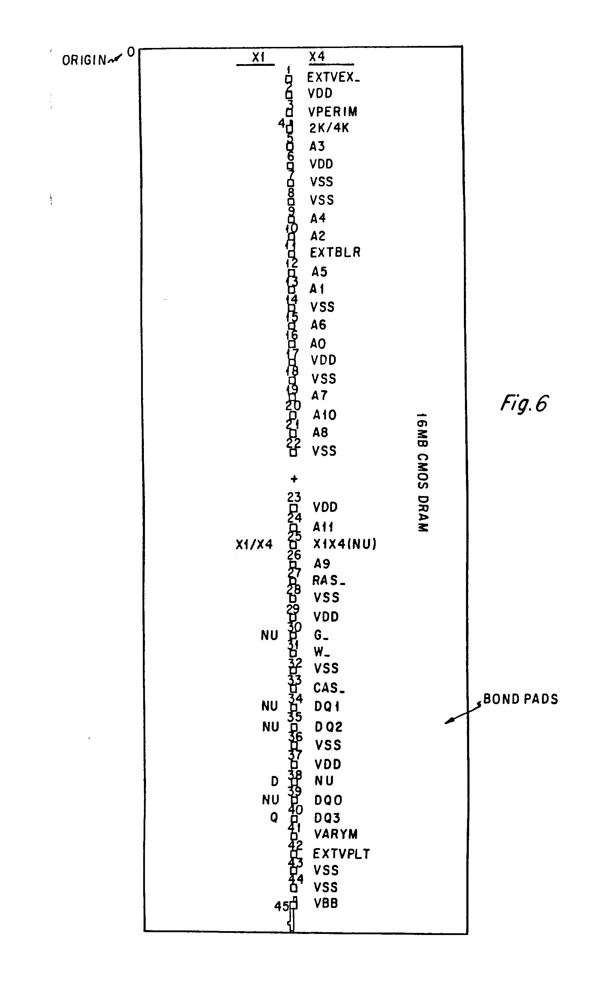

FIG. 6 is a diagram illustrating the names and sequence of the bond pads. The sequence for both the X1 and the X4 options are illustrated. EXT BLR is a pad that is for in-house only. The brackets, such as those for bond pad 4 and 25 indicate that this is a bond pad option.

General characteristics of the 16MB DRAM device of FIG. 1 follow. The device receives external VDD of typically 5 volts. On chip internal voltage regulation powers the memory arrays at 3.3 volts and the periphery circuits at 4.0 volts to reduce power consumption and channel hot carrier effects. The substrate is biased at -2 volts. The organization is bond programmable X1/X4. The X1 or X4 option may be selected during manufacture by putting in place a bond wire between bond pad 25 (FIG. 6) and $V_{SS}$ for a X1 device and omitting the bond wire for a X4 device. The resulting pin outs for the ten options may be seen in FIG. 2. The bond wire may be run between pad 25 and the $V_{SS}$ bus 3 of the lead frame (FIG. 3).

The enhanced page mode is the preferred option, with a metal mask programmable option for a write per bit (data mask) operation.

The preferred option for the refresh scheme is 4096 cycles at 64ms. However, the DRAM is bond programmable for 2048 cycle refresh. Option selection may be achieved in a way analogous to that employed for the X1 or X4 option selection. The relevant bond pad is 4, bonded to $V_{SS}$ for 2K refresh, otherwise the 4K refresh option is exercised.

The DRAM has numerous design-for-test features. Test mode entry 1 is through WCBR with no address key for 16X internal parallel test with mode data compare. Test mode entry 2 is WCBR with over-voltage and address key only thereafter (8 volts on A11). Exit from test mode occurs from any refresh cycle (CBR or RAS only). Test mode entry 1 is the industry standard 16X parallel test. This test is similar to those used on the 1MB and 4MB DRAMS, except that 16 bits are compared simultaneously instead of 8 bits. The valid address keys are A0, A1, A2, and A6. Test mode entry 2 contains numerous tests. There is a 32X parallel test with data compare and a 16X parallel test with data compare. Different hexadecimal addresses are keyed for the different parallel tests. A storage cell stress test and a VDD margin test allows connection of the external VDD to internal VARY and VPERI device supply lines through the P-channel devices. Other tests include a redundancy signature test, a row redundancy roll call test, a column redundancy roll call test, a row transfer test, a word-line leakage detection test, clear concurrent test modes, and a reset to normal mode. The DRAM also contains a test validation method that indicates if it has remained in a test mode.

Although not illustrated in FIG. 1, for clarity, the DRAM contains redundancy features for defect elimination. It has four redundant rows per 256K memory block. All four may be used at one time. There are 3 decoders per redundant row and 11 row addresses per redundant row decoder. It uses fuses for row redundancy with, on-average, 10 fuses blown for a single repair. The row redundancy uses a two stage programmable concept to more efficiently to enable repair. There are 12 redundant columns per quadrant and four decoders per redundant column. There are 8 column addresses and 3 row addresses per decoder. The total fuse count for column repair is about, on average, 10 fuses blown for a single repair. Column redundancy also has a two-stage programmable feature to more efficiently enable repair.

FIG. 7 is a top view of the capacitor cell layout. The bit lines are poly-3 ($TiSi_2$) polyside. No bitline reference is used and the bitlines are triple twisted for noise immunity. The supply line voltage is about 3.3 volts. The word lines are segmented poly-2. They are strapped every 64 bits with metal 2. The memory cells are of the modified trench capacitor type and may be formed by a process such as disclosed in United States Patent 5,017,506 and European Patent Application 0410288.

Alternative suitable memory cells of the stacked trench-type are disclosed in United States Patent 4,978,634.

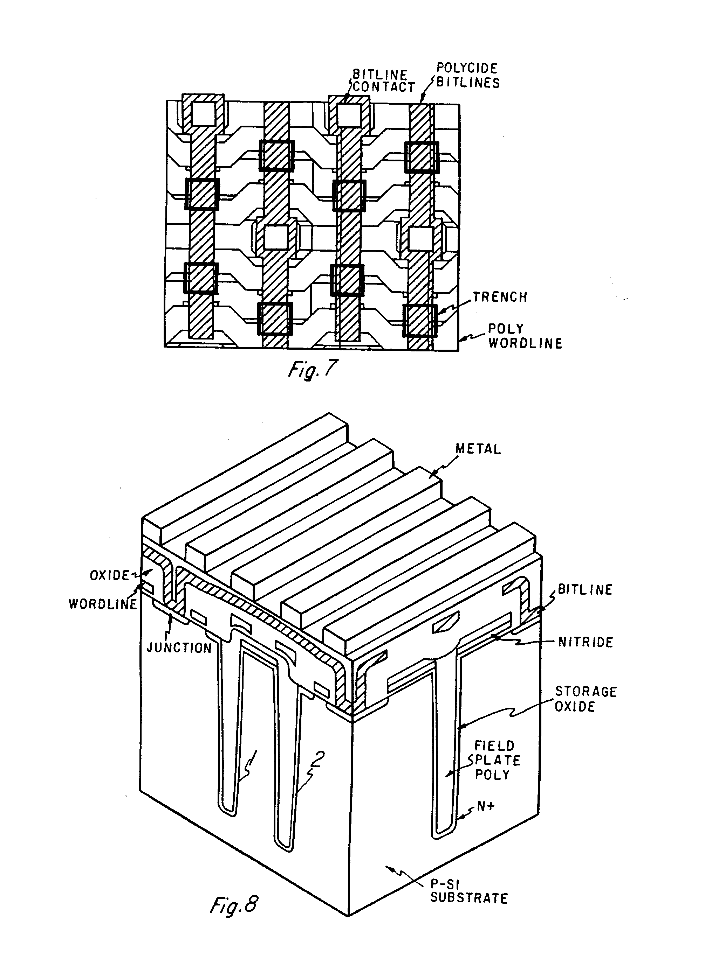

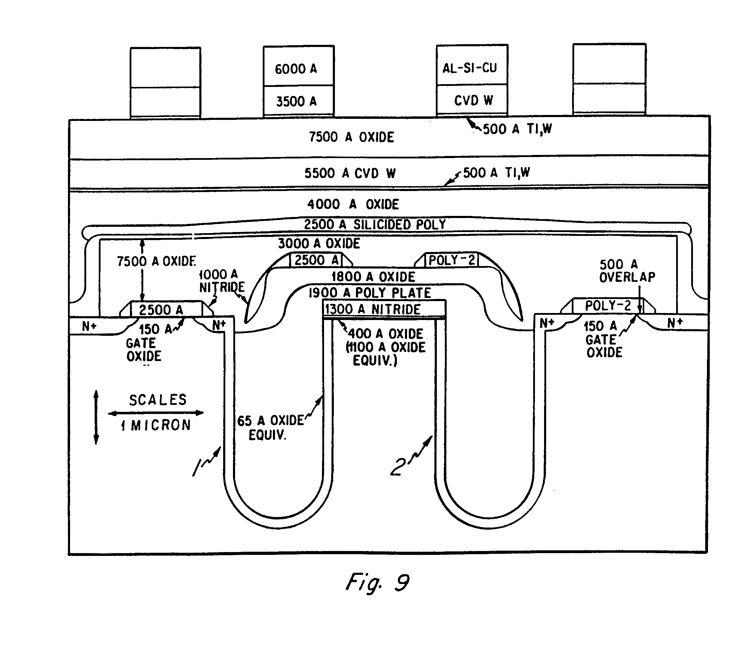

In FIG. 7, the dimensions include a 1.6um bit-line pitch by 3.0um double word line pitch, with a cell size of about $4.8um^2$ obtained through 0.6 micron technology. The trench opening is about 1.1um and the trench depth is about 6.0um. The dielectric is of nitride/oxide, having a thickness of about 65A. Field plate isolation is utilized. The transistors have thin gate oxide. FIG. 8 is a cross-sectional view of the modified trench capacitor cell and FIG. 9 is a side view of the trench capacitor cell.

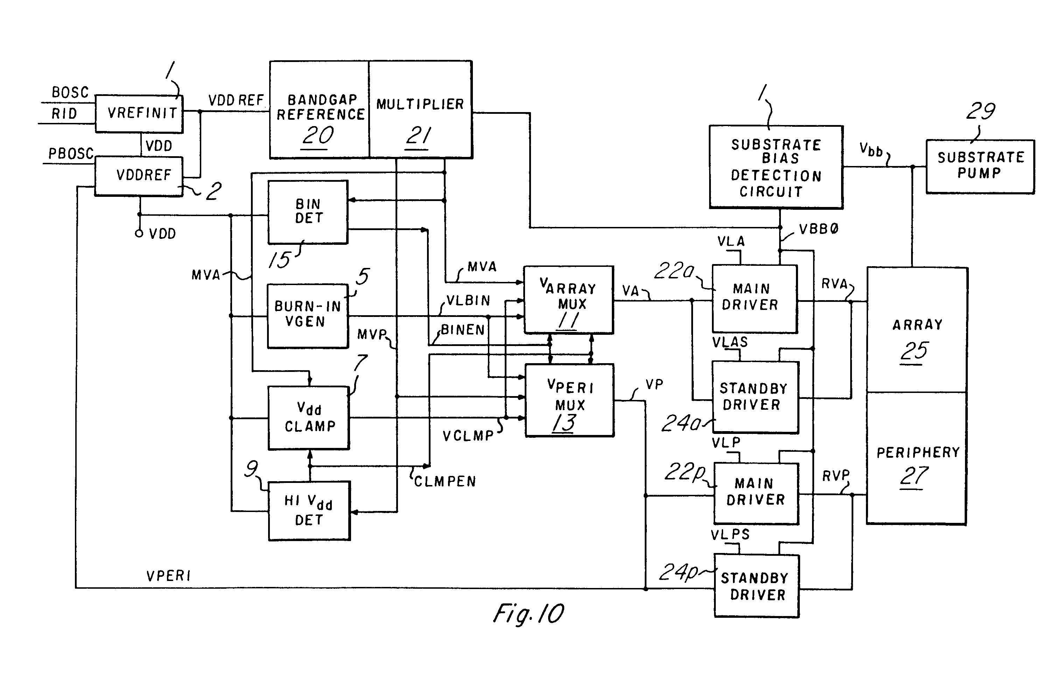

FIG. 10 shows the overall arrangement for generating VDDREF and how it is used in the DRAM. The starter circuit VREFINIT(1) receives a signal RID, present during the initial power up phase of the device, to switch the external supply voltage VDD to the band gap voltage reference generator 20 to start the generator. The start up circuit also receives a signal BOSC from an oscillator which is activated as power up continues. This oscillator is used to drive a pump to, in turn, drive the output VDDREF even after RID has gone to the inactive state. The oscillator producing BOSC may conveniently be the same oscillator that is used initially to bias the device substrate. At the end of power up the signal BOSC will thus cease.

When power up is complete, a signal PBOSC is available to drive the main power VDDREF. The oscillator which forms part of the power supply charge pump may conveniently be used. In this embodiment the oscillator of the pump which supplies the substrate bias when the device is in a standby mode is employed. After power up the voltage VPERI, the supply used for the access circuits to the DRAM array, is available and is used as an output to VDDREF for reference purposes. The supply fed to the bank gap generator is thus decoupled from changes in external supply VDD once the device is powered up. This contrasts with the normal arrangement of using VDD itself to supply the bandgap generator.

Multiplier 21 supplies the various circuits as shown. During normal operations VREFINIT is inactive, however, where BOSC is the oscillator of the substrate bias booster pump, VREFINIT may be energized in its charge pumping configuration, whenever the substrate bias detector energizes the booster. Since VREFINIT operates in parallel with VDDREF, extra supply capability is available during substrate boost. The circuits of FIG. 10 will now be considered in more detail.

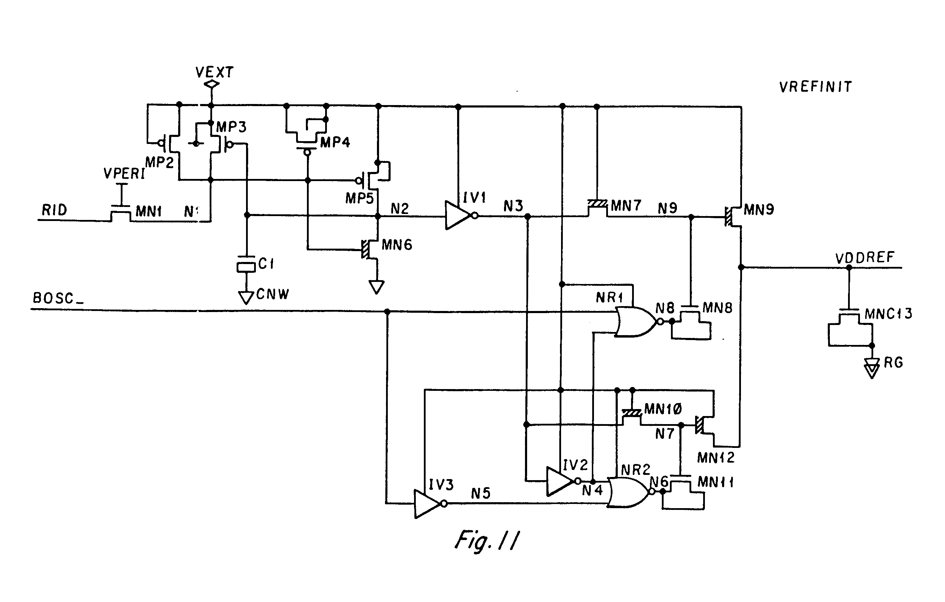

FIG. 11 illustrates the Voltage Reference Initialization circuit VREFINIT. N-channel transistor MN1 is connected between Node N1 and the input signal RID. The gate of transistor MN1 is connected to VPERI. P-channel transistor MP2 is connected between external VDD and Node N1. The gate of P-channel transistor MP2 is connected to VDD. P-channel transistor MP3 is connected to between VDD and Node N1. The gate of P-channel transistor MP3 is connected to Node N2. The gates of P-channel transistors MP4 and MP5 are connected to Node N1. The source and drain of transistor MP4 is connected to VDD. One terminal of transistor MP5 is connected to VDD. The other terminal is connected to Node N2. Node N2 is connected to the gate of N-channel transistor C1. The source and drain of transistor C1 are connected to VSS. Node N1 is connected to the gate of N-channel low threshold voltage transistor MN6. Transistor MN6 is connected between Node N2 and VSS. Node N2 is connected to the input of inverter IV1. The output of the inverter IV1 is connected to Node N3. Inverter IV1 is biased by VDD.

In the Voltage Reference Initialization Circuit, VREFINIT of FIG. 11, Node N3 is connected to the input of inverter IV2. Inverter IV2 is biased by VDD. Its output is connected to the inputs of NOR gate NR1 and NR2. BOSC__ is connected to the input of NOR gate NR1 and is coupled to the input of NOR gate NR2 through inverter IV3. Inverter IV3 and NOR gates NR1 and NR2 are biased by VDD. The output of Nor gate NR1 is connected to Node N8. The output of Node NR2 is connected to N6.

In FIG 11, N-channel low threshold voltage transistor MN7 is connected between Node N3 and Node N9. Its gate is connected to VDD. Node N9 is connected to the gate of N-channel transistor MN8. It's source and drain are connected to Node N8. N-channel low threshold voltage transistor MN9 is connected between VDD and VDDREF. It's gate is connected to Node N9. N-channel low threshold voltage transistor MN10 is connected between Node N3 and Node N7. Its gate is connected to VDD. Node N7 is connected to the gate of N-channel transistor MN11. The source and drain of transistor MN11 are connected to Node N6. Node N7 is also connected to the gate of N-channel low threshold Voltage transistor MN12. Transistor MN12 is connected between VDD and VDDREF. The gate of N-channel transistor MNC13 is connected to VDDREF. The source and drain of transistor MNC13 are connected to VSSREG.

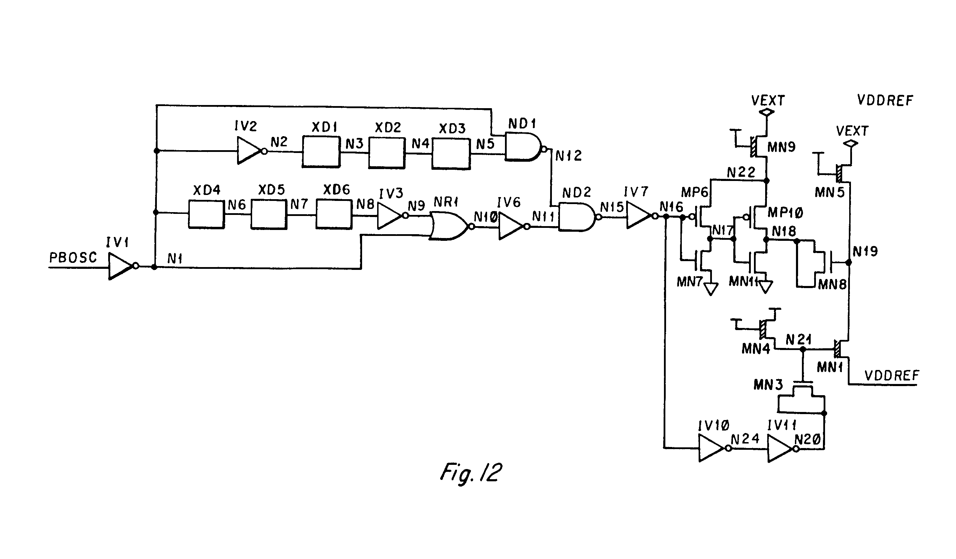

FIG. 12 illustrates the VDD Reference circuit VDDREF. Signal PBOSC is coupled through inverter IV1 to Node N1. Node N1 is coupled through the serially connected inverter IV2, and delay stages XD1, XD2, and XD3 to an input of NAND gate ND1. Node N1 is directly connected to the other input of NAND gate ND1. Node N1 is directly connected to one input of NOR gate NR1. It is coupled through the serially connected delay stages XD4, XD5, and XD6 and inverter IV3 to the other input of NOR gate NR1. The output of NOR gate NR1 is coupled through inverter IV6 to one input of NAND gate ND2. The other input to NAND gate ND2 is the output of NAND gate ND1.

In the VDD reference circuit, VDDREF of the output of NAND gate ND2 is coupled through inverter IV7 to Node N16. Node N 16 is connected to the gates of P-channel transistor MP6 and N-channel transistor MN7. Transistors MP6 and MN7 are respectively connected between Node N22 and VSS. Low-threshold voltage N-channel transistor MN9 is connected between VDD and Node N22. Its gate is connected to VPERI. P-channel transistor MP10 and N-channel transistor MN11 are connected respectively between Node N22 and VSS. The gates of P-channel transistor NP10 and N-channel transistor MN11 are connected to the series connection between transistor MP6 and MN7.

In FIG. 12, N-channel low threshold voltage transistor MN5 and N-channel low threshold voltage transistor Mn1 are connected respectively between VDD and BDDREF. The gate of transistor Mn5 is connected to VPERI. The gate of transistor MN1 is connected to Node N21. The gate of N-channel transistor MN8 is connected to the series connection of transistors MN5 and Mn1. The source and drain of transistor Mn8 are connected to the series connection of transistors M10 and MN11. Los-threshold voltage N-channel transistor MN4 is connected between VPERI and node N21. The gate of N-channel transistor MN3 is connected to Node N21. The source and drain of transistor MN3 are connected together and connected to the output of inverter IV11. Node N16 is coupled through inverter IV10 to the input of inverter IV11.

The circuit that generates the supply to the reference voltage generator is shown in figures 11 and 12. The circuit in Figure 12 operates once the on-chip regulated supply has powered up and provides the isolation to the reference voltage generation from external voltage slews. The circuit in FIG. 11 operates only during initial power up and is turned off once the chip has reached stable operation. Since the circuit in FIG. 12 depends on the on-chip regulated supply, some initial source of power is needed for the reference voltage generator so the on-chip regulated supply can be established.

A filtered supply is provided for the reference voltage generator that draws its power from the on-chip regulated supply, in such a way that the two will not collapse together should the on-chip regulated supply vary somewhat. In this way, since the on-ship regulated supply does not vary with external voltage slew, the supply to the reference voltage generator will not vary with the external slew. by setting the voltage of the supply to the reference voltage generator sufficiently above the on-chip regulated supply level, and insuring that the response time of this supply is greater than that of the on chip regulated supply, even though the on-chip regulated supply may drop momentarily in value.

Referring to FIG. 12, PBOSC is a signal that comes from the oscillator used to generate the substrate bias voltage. This signal has a typical period of oscillation of approximately 1us with approximately 505 duty cycle. The circuitry comprised if IV1, IV2, IV3, IV6, XD1-SD6, NR1 and ND1-ND2 is used to generate a positive pulse of approximately 12ns duration at N15 on each transition of PBOSC. The remainder of the circuit in FIG. 1 forms a charge pump to supply charge to the reference voltage generator and capacitor MNC13 in FIG. 11 is used to smooth the voltage ripple seen by this generator.

During the period of time that N15 is positive, capacitor MN8 charges to VPERI-Vt. By using VPERI to limit the voltage that this capacitor can charge to, the dependence on the external Vdd is eliminated. When N15 returns low, N19 and N21 are bootstrapped, thus pumping charge onto VDDREF, the supply to the reference voltage generator. Devices MN5 and MN9 have their drains connected to external Vdd to reduce the load on VPERI and further stabilize the on-chip regulated supply.

5

In FIG. 11, BOSC__ is an oscillator input that is generated only during initial power up or whenever the substrate bias voltage becomes too positive. This circuit is intended only to initialize VDDREF so that VPERI can initially be generated. RID is a control signal that powers up high and remains high until the internal supplies are stabilized. Once this occurs RID goes low and remains low for as long as the chip is powered up. NR1-NR2 are gates that allow BOSC__ to charge smoothing capacitor MNC13 to Vdd during initial power up. Once RID goes low, these gates prevent BOSC__ from reactivating charging to Vdd. Circuitry consisting of MN1, MP2, MP3, MP4, MP5 MN6 and C1 is designed to cause N2 to power up low prior to RID being established at its initial high state. MN9 and MN12 are bootstrapped, each on alternate states of BOSC__, such that VDDREF is charged to Vdd during the period of time that RID is high.

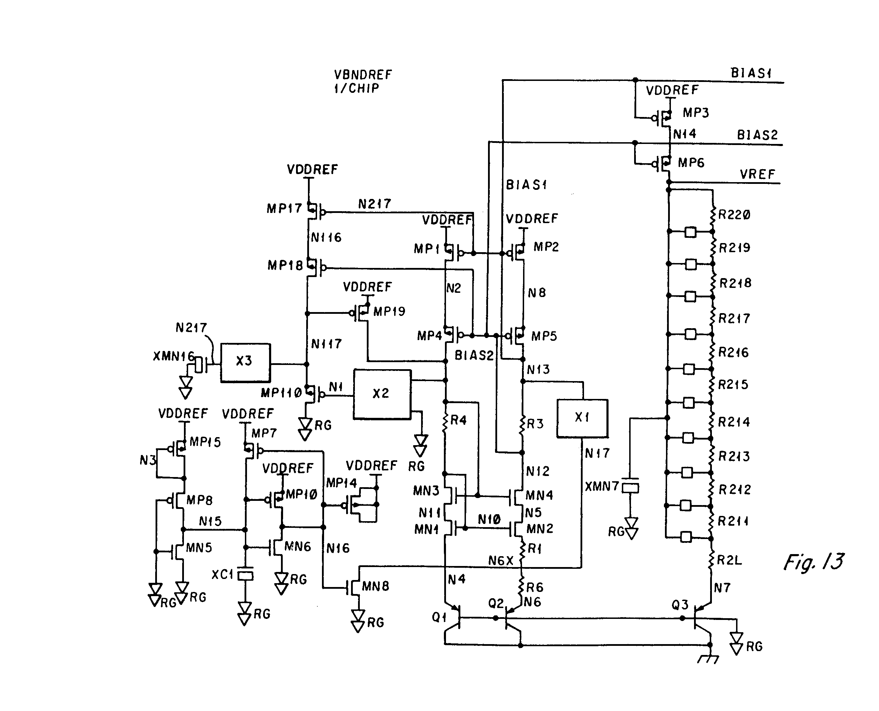

VBNDREF     - VOLTAGE REFERENCE GENERATOR
                   - schematic FIG. 13


Voltage Regulation

This circuit generates a reference voltage. Besides providing a stable voltage, it is designed to have immunity towards changes in temperature. A standard BANDGAP REFERENCED BIASING circuit is improved to achieve this.

The bandgap referenced biasing circuit is comprised of transistors, MP1 through MP6, MN1 through Mn4 and Q1 through Q3. Constant current that follows along the 3 electrical path is governed by the equation;

$$i = \frac{VT * \ln ( \text{emitter area Q2} / \text{emitter area Q1} )}{\text{Resistance, R1}}$$

; where VT is the thermal voltage

; the 3 paths mentioned are:

- MP1 to Q1
- MP2 to Q2
- MP3 to Q3


With this constant current, the output voltage, VREF is obtained by the summation of potential drops across resistor R2 and across emitter-base of Q3.

$$\begin{aligned} VREF &= ( i * R2 ) + Vbe \\ &= (VT * \ln 8 * R2/R1 ) + Vbe \end{aligned}$$

; where ratio of emitter area of Q2 to Q1 is 8.

Here, a regulated voltage is achieved, ie VREF does not depend on the external voltage. But note that the parameters that generate VREF are temperature dependent parameters. Thus, VREF changes with temperature.

Knowing that Vbe has negative temperature coefficient while Vt and R1 and R1 have positive temperature coefficient, simulations were made to obtain R1 and R2 such that the resultant change in VREF due to temperature is zero. R1 is first determined by fixing the constant current to the region of 0.5uA. Through simulation, the operation of VREF is to be 1.2V and R1 and R2 are to be 5.4 Kohms and 51.3 Kohms respectively.

To achieve a wider operating range, another modification was made on the standard circuit. The new circuit is designed to start its voltage regulation of a Vt lower than the standard circuit.

Note that, for a transistor to operate in its saturation region, the following condition needs to be satisfied.

/Vds/ greater or equal to /Vgs - Vt/

In the standard circuit, the gates of a P-channel and N-channel transistors are tied to the drain, thus forcing the device into its saturation region, (here /Vds/> /Vgs - Vt/), when Vds reaches active Vgs level. But for the device to be in saturation, Vds needs only to be at a lower value, ie: /Vds/ = /Vgs-Vt/.

So, instead of tying the gate to the drain, the gate is tied to a point of magnitude that is about one Vt potential above the drain potential. Hence, the device is activated into its saturation region as Vgs is activated with Vds is one Vt below Vgs. Thus, the device is operational at a lower voltage level.

That is the reason that in the Bandgap Referenced Biasing circuit, gate of MP1/MP2 is tied to drain of MP5, gate of MN1/MN2 is tied to drain of MN3, gate of MN4/MN5 tied to drain of MP4 with R4 to provide to potential drops, and gate of MP4/MP5 tied to drain of MN4 with R3 to provide the potential drops.

If the external voltage is too low, the transistors in the Bandgap Referenced Biasing are inactive. Thus, there will not be any output voltage at VREF. But we would like to have some small signal level at the output and require it to increase gradually as the external voltage increases. To achieve this, two low voltage starter circuits are incorporated into the design.

The first low voltage starter drives current into R4 and then the drain of MN3 at low external voltage. This circuit is comprised of MP17, MP18, MP19, MP110 and MN16. At low external voltage, with MP17 and MP18 off, current is driven into node N13 through MP19 with MN16 keeping node N117 low. MP110 is used to discharge capacitor MN16 when the external supply goes too low. But when the external voltage is sufficient to turn on the Bandgap Referenced Biasing transistors, Mp17 and MP18 are turn one, thus charging up M16 and turning off mP19. This allows the normal biasing mode to operate.

The second low voltage starter sinks current from the drain of MP5. At low voltage startup, C1 keeps N15 low, thus turning on MP10 and MN8. This helps to switch on MP5 and MP2. By so doing, it forces current to flow in them.

With the current generated by the above two circuits, the current mirror effect takes place and generates current into R2. This provides the voltage at VREF. Note, that this is not a regulated voltage.

Besides, generating the VREF, two other signals are routed for use in other circuits. They are the BIAS1 and BIAS2 signals. They are used to generate a similar current flow in other circuits through the current mirror effect.

Capacitor MN7 serves as a stabilizer for VREF.

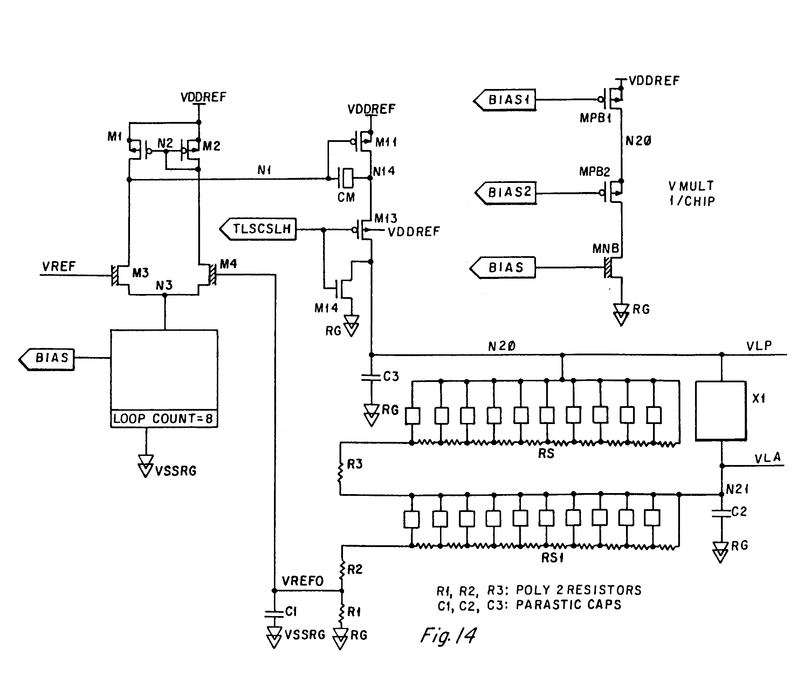

VMULT     - VOLTAGE MULTIPLIER
                - schematic FIG. 14

From VBDNREF, we have a regulated voltage of 1.2V. To get the required voltage level of 3.3V and 4V, VMULT uses the concept of a potential divider to multiply VREF to the required voltage levels.

By using BIAS1 and BIAS 2, a constant current source is generated at node N3 of the source coupled pair, M3 and M4. The gate of M3 is connected to VREF, and the gate of M4 is connected to node VREFO of a series of resistors. This source couple pair compares the voltage VREF and VREFO. Differential voltages cause different current flows in M3 and M4. With this current mirror, it will try to maintain the same current flowing through M3 and M4, thus maintaining the same current. The circuit maintains VREFO to equal to VREF.

With VREFO maintained at VREF, and current through R1, R2 and R3 the same, we have a voltage multiplier circuit, where the output voltages are:

$$V1a = \{( R1 + R2 )/R1 \} * VREFO$$
$$\text{and } V1p = \{( R1 + R2 + R3 )/R1\} * VREFO$$

R2 and R3 are trimable resistors in order to achieve the required levels of 3.3V and 4V. Capacitor CM is to provide damping to the feedback node N1.

If the device is operating in DFT CELL STRESS mode, active TLSCSLH shuts off the supply line for the voltage multiplier and grounds it. Thus, both outputs VPRP and VARP will be at GND level.

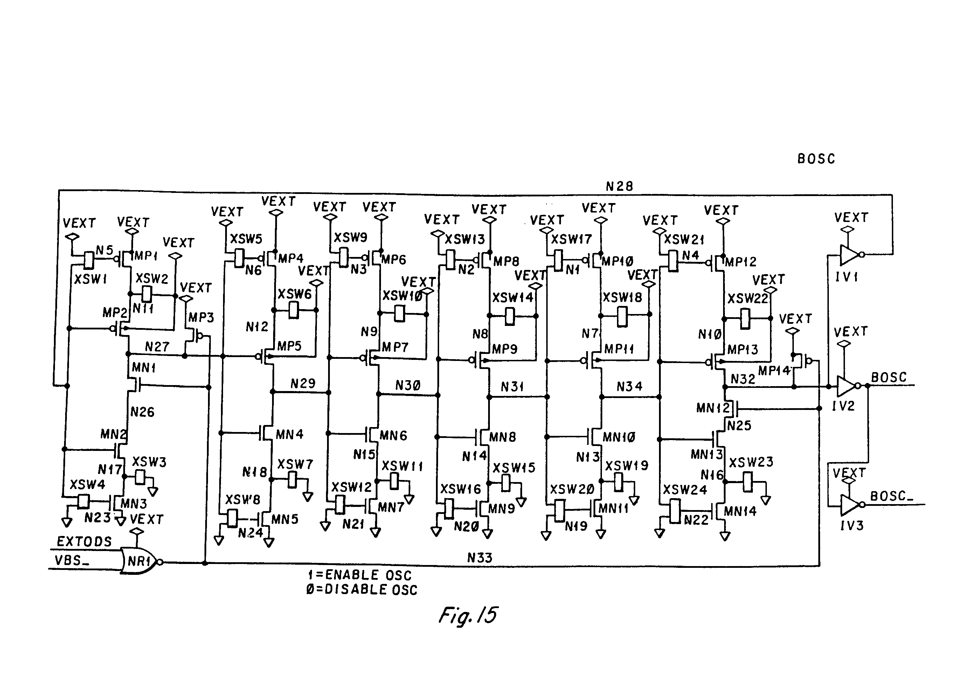

BOSC     - BOOSTER OSCILLATOR
                - schematic FIG. 15

The oscillator BOSC uses external voltage VDD (VEXT) as supply. The oscillator provides square waveforms of 3MHz.

The circuit is designed with seven inverters connected in feedback loop to produce a ring oscillator. One stage having a different transfer ratio to the oscillator can start up automatically when power is applied. Each stage having programmable transistor sizes to allow some adjustment in the frequency of oscillation.

BOSC is gated on and off by VBS__ which is controlled by VBBDET, the substrate bias voltage detector circuit. Thus, when VBB is insufficient, VBS__ will be low and BOSC will be activated. BOSC drives the booster pump VBBPB which generates the substrate bias during power up.

An externally applied signal EXTODS, can be used to disable the oscillator, and indirectly their pumps if substrate bias is to be applied externally.

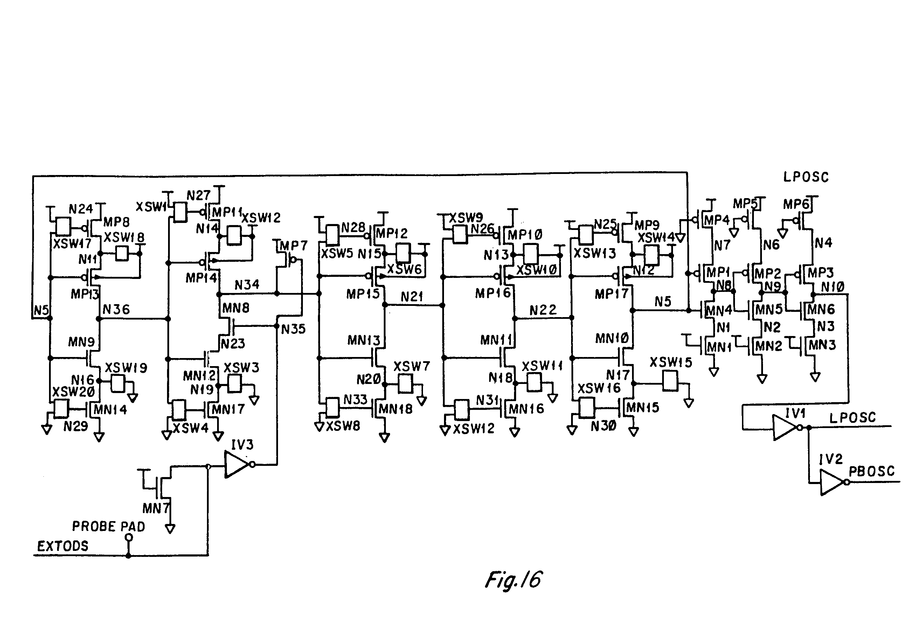

LPOSC      - LOW POWER OSCILLATOR
             - schematic FIG. 16

This oscillator generates a square wave signal which drives the low power or the standby VBB pump. A loop of five inverters is used to provide a signal of about 1 usec cycle time, 1MHz. These inverters are designed with programmable sizing of the P-channel and N-channel transistors. This enables adjustment of oscillator frequency when needed, achieving the required cycle time by controlling the W/L ratio of the inverters. The resulting waveform has a slow rise and fall time. To convert this signal into a square waveform, a set of 3 modified inverters is connected to the output of the loop, ie node N5. These inverters amplify the signal, increasing the rise and fall times until a square wave is generated.

The oscillating signal can be inhibited by injecting a high level signal at probe pad EXTODS. This breaks the loop of inverters and forces node N5 to a low potential. Thus, the output LPOSC is forced low and becomes a static output.

There are two outputs, LPOSC and BPOSC. LPOSC is used for the VBB pump and PBOSC is used as booting signal for various parts of the device.

Finally, note that the transistors MN11 and MN16 are sized differently from the other inverters. This is to avoid the situation where the output is locked at an intermediate level at power up. this is accomplished by changing the D.C. transfer curve of one inverter in the loop of five inverters.

## Claims

1. A voltage reference initialization circuit for a voltage reference generator comprising:

   a starter circuit connected to the input of the voltage reference generator and to an external voltage supply, initially to couple the input of the reference generator to the external voltage supply and thereby start the reference generator; and

   a pump circuit connected to the input of the reference generator, coupled to the output of the reference generator, and connected to the external voltage supply, to pump a fixed charge from the external voltage supply into the voltage reference generator in dependence upon said reference generator output.

2. The voltage reference initialization circuit of claim 1 wherein the pump circuit includes:

   a capacitor connected to the input of the voltage reference generator; and

   a transistor coupled between the external voltage supply and the capacitor, the gate of the transistor being coupled to the output of the voltage reference generator.

3. The voltage reference initialization circuit of claim 2 wherein the pump circuit further includes:

   a pulse generation circuit coupled to the capacitor wherein the capacitor charges in response to the pulses it receives from the pulse generation circuit.

4. An integrated circuit device including a voltage reference generator and a voltage reference generator initialization circuit as claimed in any preceding claim.

5. An integrated circuit device as claimed in claim 4 and including means for biasing the device substrate, said starter circuit being energized when said biasing means is active.

6. An integrated circuit device as claimed in claim 4 or claim 5 and including

   an array of memory cells;

   circuitry for writing and reading information into and from said cells of said array;

   said array being supplied from a voltage derived from said voltage reference generator.

7. An integrated circuit device as claimed in claim 6 and wherein said circuitry for writing and reading information is supplied by said voltage reference generator output.

*Fig. 1*

Fig.2

DQO

DQ1

VDD

RAS_

W_

A11

A10

AO

A1

A2

A3

DD

VSS

DQ3

DQ2

CAS_

G_

A9

A8

A7

A6

A5

A4

BOND PADS

VSS

Fig. 3

LEADFRAME

TAPE

CHIP

Fig. 4

Fig. 5

EP 0 470 498 A2

ORIGIN 0

| | X1 | X4 |
|---|---|---|
| 1 | | EXTVEX_ |
| 2 | | VDD |
| 3 | | VPERIM |
| 4 | | 2K/4K |
| 5 | | A3 |
| 6 | | VDD |
| 7 | | VSS |
| 8 | | VSS |
| 9 | | A4 |
| 10 | | A2 |
| 11 | | EXTBLR |
| 12 | | A5 |
| 13 | | A1 |
| 14 | | VSS |
| 15 | | A6 |
| 16 | | A0 |
| 17 | | VDD |
| 18 | | VSS |
| 19 | | A7 |
| 20 | | A10 |
| 21 | | A8 |
| 22 | | VSS |
| 23 | | VDD |
| 24 | | A11 |
| 25 | X1/X4 | X1X4(NU) |
| 26 | | A9 |
| 27 | | RAS_ |
| 28 | | VSS |
| 29 | | VDD |
| 30 | NU | G_ |
| 31 | | W_ |
| 32 | | VSS |
| 33 | | CAS_ |
| 34 | NU | DQ1 |
| 35 | NU | DQ2 |
| 36 | | VSS |
| 37 | | VDD |
| 38 | D | NU |
| 39 | NU | DQ0 |
| 40 | Q | DQ3 |
| 41 | | VARYM |
| 42 | | EXTVPLT |
| 43 | | VSS |
| 44 | | VSS |
| 45 | | VBB |

16MB CMOS DRAM

Fig.6

BOND PADS

12

Fig. 7

Fig. 8

*Fig. 9*

Fig.10

Fig. II

*Fig. 12*

EP 0 470 498 A2

Fig. 13

Fig. 14

R1, R2, R3: POLY 2 RESISTORS
C1, C2, C3: PARASTIC CAPS

Fig. 15

1=ENABLE OSC
0=DISABLE OSC

Fig.16

21